Europäisches Patentamt

European Patent Office

Office européen des brevets

(19)

(11) **EP 0 715 990 A2**

(12) **EUROPÄISCHE PATENTANMELDUNG**

(43) Veröffentlichungstag:
     12.06.1996 Patentblatt 1996/24

(51) Int. Cl.⁶: **B60R 16/02**

(21) Anmeldenummer: 95118592.5

(22) Anmeldetag: 25.11.1995

(84) Benannte Vertragsstaaten:
     FR GB IT SE

(30) Priorität: 06.12.1994 DE 4443351

(71) Anmelder: **Hella KG Hueck & Co.**
     **D-59552 Lippstadt (DE)**

(72) Erfinder: **Trinschek, Martin**
     **D-59067 Hamm (DE)**

(54) **Schaltungsanordnung und Verfahren zur Ansteuerung und Überwachung elektrischer Lasten in einem Kraftfahrzeug**

(57)     Beschrieben wird eine Schaltungsanordnung und ein Verfahren zur Ansteuerung der Überwachung elektrischer Lasten in einem Kraftfahrzeug.

Die Schaltungsanordnung besteht aus einer Ablaufsteuerungseinrichtung (vorzugsweise Mikroprozessor mit einem integrierten AD-Wandler), mehreren Lastschalters (Relais oder elektronische Schalter) und aus einem Prüfschalter. Die an den Lasten anliegenden Spannungen werden der Ablaufsteuerungseinrichtung zugeführt. Die Schaltungsanordnung eignet sich zur Überwachung von Lastgruppen, die alle entweder an Masse oder die Betriebsspannung angeschlossen sind.

EP 0 715 990 A2

## Beschreibung

Die Erfindung betrifft eine Schaltungsanordnung zur Ansteuerung und Überwachung elektrischer Lasten in einem Kraftfahrzeug, mit elektrischen Lasten, die über steuerbare Lastschalter an eine Spannung anschaltbar sind, und einer Ablaufsteuerungseinrichtung, die die steuerbaren Lastschalter ansteuert und die von jeder Last ein Spannungssignal abgreift.

Solche Schaltungsanordnungen zur Überwachung elektrischer Lasten besitzen üblicherweise einen Meßwiderstand, der mit der elektrischen Last in Reihe geschaltet ist, wobei zur Überwachung der Last der Spannungsabfall an dem Meßwiderstand ausgewertet wird.

Hierbei ist nachteilig, daß besonders bei sehr niederohmigen elektrischen Lasten der Meßwiderstand ebenfalls sehr niederohmig ausgeführt sein muß, um die Funktion der elektrischen Last nicht zu beeinträchtigen.

Solche niederohmigen Meßwiderstände sind aber nur auf aufwendige Weise zu fertigen und besitzen relativ große Abmessungen. Nachteilig ist auch, daß zur Auswertung der sehr geringen Spannungen, die an niederohmigen Meßwiderständen abfallen, ein erheblicher Schaltungsaufwand erforderlich ist. Diese Auswerteschaltungen sind zudem besonders gegenüber elektromagnetischen Störeinflüssen empfindlich.

Es soll daher eine Schaltungsanordnung geschaffen werden, bei der zur Prüfung kein Reihenwiderstand im Lastkreis benötigt wird.

Aus der DE 35 33 523 C2 ist eine Schaltungsanordnung bekannt, bei der kein Reihenwiderstand zwischen Lastschalter und Last vorgesehen ist. Die Schaltungsanordnung weist hierzu einen Komparator auf, der den Spannungsabfall an elektrischen Lastschaltern mit einer Referenzspannung vergleicht.

Hierbei ist nachteilig, daß eine Überprüfung des Lastkreises nur auf Unterbrechung oder Kurzschluß erfolgt. Quantitative Eigenschaften der Lasten, insbesondere deren Widerstandswerte können mit dieser Anordnung nicht geprüft werden. Besonders nachteilig bei dieser Schaltungsanordnung ist, daß eine Überprüfung der Lasten nicht möglich ist, wenn gleichzeitig mehrere Lasten eingeschaltet sind.

Es ist daher die Aufgabe der Erfindung, eine einfache und kostengünstige Schaltungsanordnung zu schaffen, die ohne einen Reihenwiderstand im Lastkreis auskommt und trotzdem die Überwachung quantitativer Eigenschaften der Last, und zwar unter Vermeidung der oben genannten Nachteile ermöglicht.

Diese Aufgabe wird erfindungsgemäß dadurch gelöst, daß die Ablaufsteuerungseinrichtung einen steuerbaren Prüfschalter ansteuert, der die elektrischen Lasten über Prüfwiderstände an die Spannung anschaltet und daß die Ablaufsteuerungseinrichtung mindestens einen Analog/Digital-Wandler zur quantitativen Auswertung der Spannungssignale aufweist.

Weiterhin löst die erfindungsgemäße Schaltungsanordnung die gestellte Aufgabe durch Ausführung folgender Verfahrensschritte:

a) die Ablaufsteuerungseinrichtung öffnet zur Überprüfung einer elektrischen Last den zugehörigen Lastschalter;

b) die Ablaufsteuerungseinrichtung schließt den Prüfschalter und verbindet so die zu prüfende Last über den Prüfwiderstand an die Spannung;

c) die Multiplex-Einrichtung schaltet die am Verbindungspunkt zwischen Prüfwiderstand und zu prüfender Last anliegende Spannung auf den Analog/Digital-Wandler, welcher das Spannungssignal in einen Digitalwert wandelt und einem Mikrocomputer zur Auswertung zuführt.

Die erfindungsgemäße Schaltungsanordnung zeichnet sich vorteilhafterweise durch einen recht einfachen Aufbau aus. Im Ausführungsbeispiel wird je zu prüfender Last jeweils nur ein Prüfwiderstand, eine Diode zur Entkopplung und ein Eingang an einer Muliplex-Einrichtung benötigt. Damit kann eine nahezu beliebige Anzahl von Lasten überwacht werden.

Besonders vorteilhaft ist, daß für die Prüfbarkeit der Lasten der Schaltzustand der Lasten beliebig ist. Insbesondere können mehrere oder sogar alle Lasten gleichzeitig eingeschaltet sein.

Auch der Schaltzustand der gerade zu prüfenden Last ist beliebig, da der Prüfvorgang nur eine kurze Unterbrechung der Einschaltung der Last erfordert. Besonders vorteilhaft ist auch, daß elektrische Eigenschaften der Lasten quantitativ geprüft werden können. Dies ist beispielsweise nötig, wenn die Lasten im Bereich ihrer Leistungsgrenzwerte betrieben werden sollen. Die Ablaufsteuerungseinrichtung kann durch die quanitative Prüfung der Lasteigenschaften erkennen, ob eine Last den vorgesehenen Belastungen standhalten kann. Ist dies nicht der Fall, kann die Ablaufsteuerungseinrichtung ein Warnsignal oder Diagnosesignal abgeben oder (gegebenenfalls) die Ansteuerzeit der Last absenken, um eine Überlastung zu vermeiden.

Weitere vorteilhafte Ausgestaltungen und Weiterbildungen der erfindungsgemäßen Schaltungsanordnung gehen aus den Unteransprüchen hervor.

Das an den Lasten abgegriffene Spannungssignal kann vorteilhafterweise einer Muliplexeinrichtung zugeführt werden. Hierdurch wird nur ein Analog/Digital-Wandler zur Auswertung aller an den Prüfwiderständen abgegriffenen Spannungssignale benötigt. Der dem Analog/Digital-Wandler zugeführte Spannungswert wird von diesem in ein digitales Signal umgewandelt und an einen Mikrocomputer gegeben, der die Spannungshöhe der Last als in Ordnung oder als fehlerhaft beurteilt.

Mittels eines weiteren Analog/Digital-Wandlers oder über einen weiteren Eingang der Multiplexeinrichtung kann zudem der Wert der Betriebsspannung dem Mikrocomputer als digitales Signal zugeführt werden, wodurch der Mikrocomputer unter Zuhilfenahme der Prüfwiderstandswerte auch die Widerstandswerte der Lasten bestimmen kann. Hierdurch kann neben der üblichen Prüfung auf Kurzschluß oder Unterbrechung des Lastkreises auch eine längerfristige Veränderung der Lastwiderstände festgestellt werden.

Besonders vorteilhaft ist auch, daß die intelligente Ablaufsteuerungseinrichtung auf einfachste Weise eine Vielzahl von Lasten, die ganz verschiedenartige Widerstandswerte aufweisen, prüfen kann.

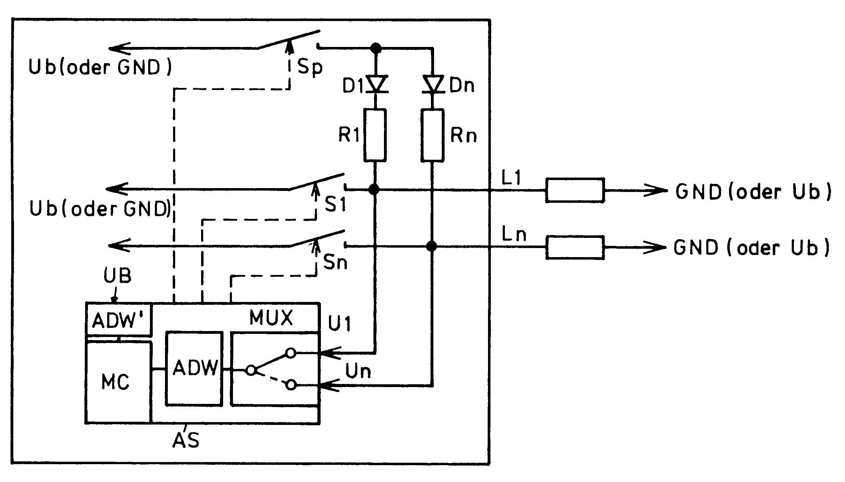

Die einzige Figur zeigt als Ausführungsbeispiel ein Blockschaltbild einer erfindungsgemäßen Schaltungsanordnung, anhand derer auch das erfindungsgemäße Prüfverfahren erläutert werden soll.

Eine beliebige Anzahl von Lasten (hier beispielhaft durch zwei Lasten (L1, LN) dargestellt), wird über jeweils einen elektromechanischen (Relais) oder elektronischen (zum Beispiel Leistungs-FET) Lastschalter (S1, SN) an die Betriebsspannung (UB) oder alternativ auch gegen Masse (GND) geschaltet.

Die Lastschalter (S1, SN) werden durch die Ablaufsteuerungseinrichtung (AS) angesteuert, wobei die Ablaufsteuerungseinrichtung (AS) zur Ausführung von Steuerungsaufgaben einen Mikrocomputer (MC) aufweist.

An den Verbindungspunkten von Lastschaltern (S1, SN) und Lasten (L1, LN) wird jeweils eine Spannung (U1, UN) abgegriffen und der Ablaufsteuerungseinrichtung (AS) zugeführt. Die Ablaufsteuerungseinrichtung (AS) führt die Spannungswerte (U1, UN) zeitlich nacheinander über eine Multiplexeinrichtung (MUX) einem Analog/Digital-Wandler (ADW) zu, welcher wiederum ein digitales Signal, das den zugeführten Spannungswert repräsentiert, an den Mikrocomputer gibt.

Weiterhin weist die Ablaufsteuerungseinrichtung (AS) einen zweiten Analog/Digital-Wandler (ADW') auf, der den Wert der Betriebsspannung (UB) digitalisiert und dem Mikrocomputer zuführt.

Mit jedem Verbindungspunkt von Lastschaltern (S1, SN) und Lasten (L1, LN) ist weiterhin jeweils ein Prüfwiderstand (R1, RN) verbunden, welche untereinander durch Dioden (D1, DN) entkoppelt sind und über einen Prüfschalter (SP) gemeinsam an das Potential geschaltet werden können, an welches auch die Lastschalter (S1, SN) die Lasten (L1, LN) anschalten.

Im folgenden soll das erfindungsgemäße Prüfverfahren anhand des Blockschaltbildes näher erläutert werden.

Es sei angenommen, daß die elektrischen Eigenschaften der Last (L1) überprüft werden sollen; die Schaltzustände der Lasten (L1, LN) seien beliebig.

Sofern die Last (L1) eingeschaltet ist, schaltet die Ablaufsteuerungseinrichtung (AS) diese für die kurze Dauer des Prüfvorganges ab (für viele Anwendungen ist diese Unterbrechung kaum merklich). Die Ablaufsteuerungseinrichtung schließt den Prüfschalter (SP). Mittels der Diode (D1) und des Prüfwiderstandes (R1) wird die Last (L1) mit Spannung versorgt. An der Last (L1) stellt sich eine Spannung (U1) ein, die der Ablaufsteuerungseinrichtung (AS) zugeführt wird. Die Multiplex-Einrichtung (MUX) schaltet den Spannungswert (U1) auf den Analog/Digital-Wandler (ADW), welcher den Spannungswert (U1) in ein digitales Signal wandelt und dem Mikrocomputer (MC) zuführt.

Der Mikrocomputer vergleicht das Spannungsignal mit einem vorgegebenen Sollwert für U1 und bewertet die elektrischen Eigenschaften der Last als korrekt oder fehlerhaft.

Wird eine genauere Aussage über den Widerstandswert der Last benötigt, so kann diese durch den Mikrocomputer nach der Formel

$$RL1 = U1 \times R1 / (UB - U1)$$

berechnet werden.

Werden die Lasteigenschaften als fehlerhaft beurteilt, so kann die Ablaufsteuerungseinrichtung (AS) ein Warnsignal abgeben oder im folgenden Betrieb von einer Ansteuerung der Last absehen oder die Ansteuerung der Last zeitlich begrenzen.

Nach Abschluß des Prüfvorganges setzt die Ablaufsteuerungseinrichtung (AS) die überprüfte Last (L1) durch Ansteuerung des Zugehörigen Lastschalters (S1) in ihren ursprünglichen Schaltzustand zurück.

Die restlichen Lasten werden auf analoge Weise geprüft. Nach Abschluß der Prüfung aller Lasten (L1, LN) öffnet die Ablaufsteuerungseinrichtung (AS) den Prüfschalter (SP).

Da die Prüfwiderstände nicht vom vollen Laststrom durchflossen werden, können diese, verglichen mit den Lastwiderständen, relativ hochohmig ausgeführt werden (Prüfwiderstand etwa um Faktor 10 mal größer als der zugehörige Lastwiderstand).

Aufgrund der kurzen Prüfzeiten brauchen die Prüfwiderstände auch nur eine relativ geringe Belastbarkeit aufzuweisen und können daher vorteilhafterweise recht kostengünstig ausgeführt sein.

Bezugszeichenliste

Schaltungsanordnung zur Ansteuerung und Überwachung elektrischer Lasten in einem Kraftfahrzeug

| | |
|---|---|
| ADW, ADW' | Analog/Digital-Wandler |
| AS | Ablaufsteuerungseinrichtung |
| D1, DN | Dioden |
| L1, LN | (elektrische) Lasten |
| MC | Mikrocomputer |
| MUX | Multiplexeinrichtung |
| R1, RN | Prüfwiderstände |
| S1, SN | Lastschalter |
| SP | Prüfschalter |
| U1, UN | Spannungssignale |
| UB | Betriebsspannung |
| GND | Masse |

## Patentansprüche

1. Schaltungsanordnung zur Ansteuerung und Überwachung elektrischer Lasten in einem Kraftfahrzeug, mit elektrischen Lasten (L1, LN), die über steuerbare Lastschalter (S1, SN) an eine Spannung anschaltbar sind, und einer Ablaufsteuerungseinrichtung (AS), die die steuerbaren Lastschalter (S1, SN) ansteuert und die von jeder Last (L1, LN) ein Spannungssignal (U1, UN) abgreift, dadurch gekennzeichnet, daß die Ablaufsteuerungseinrichtung (AS) einen steuerbaren Prüfschalter (SP) ansteuert, der die elektrischen Lasten (L1, LN) über Prüfwiderstände (R1, RN) an die Spannung (UB oder GND) anschaltet und daß die Ablaufsteuerungseinrichtung (AS) mindestens einen Analog/Digital-Wandler (ADW) zur quantitativen Auswertung der Spannungssignale (U1, UN) aufweist.

2. Schaltungsanordnung nach Anspruch 1, dadurch gekennzeichnet, daß genau ein Analog-Digital-Wandler (ADW) zur quantitativen Auswertung der Spannungssignale (U1, UN) vorgesehen ist und daß eine Multiplexeinrichtung (MUX) vorgesehen ist, die die Spannungssignale (U1, UN) verschiedener Lasten (L1, LN) zeitlich nacheinander an den Analog/Digital-Wandler (ADW) anschaltet.

3. Schaltungsanordnung nach Anspruch 1 oder 2, dadurch gekennzeichnet, daß die Ablaufsteuerungseinrichtung (AS) einen weiteren Analog/Digital-Wandler (ADW') zur quantitativen Bestimmung des Wertes der Betriebsspannung (UB) aufweist und das zur Ablaufsteuerungseinrichtung ein Mikrocomputer (MC) gehört, welcher aus den Signalen der Analog/Digital-Wandler (ADW, ADW') die Widerstände der überprüften Lasten bestimmt.

4. Schaltungsanordnung nach Anspruch 2, dadurch gekennzeichnet, daß auch die Betriebsspannung (UB) über die Multiplexeinrichtung (MUX) auf den Analog/Digital-Wandler (ADW) geschaltet wird und daß zur Ablaufsteuerungseinrichtung (AS) ein Mikrocomputer (MC) gehört, welcher aus den in Digitalwerten gewandelten Spannungssignalen (U1, UN) verschiedener Lasten (L1, LN) und der Betriebsspannung (UB) die Widerstände der überprüften Lasten (L1, LN) bestimmt.

5. Schaltungsanordnung nach einem der Ansprüche 1 bis 4, dadurch gekennzeichnet, daß die Lasten (L1, LN) Glühkerzen in einem Kraftfahrzeug sind.

6. Verfahren zur Überwachung elektrischer Lasten durch eine Schaltungsanordnung nach einem der Ansprüche 1 bis 5, gekennzeichnet durch folgende Verfahrenschritte:

a) die Ablaufsteuerungseinrichtung (AS) öffnet zur Überprüfung einer elektrischen Last (L1, LN) den zugehörigen Lastschalter (S1, SN);

b) die Ablaufsteuerungseinrichtung (AS) schließt den Prüfschalter (SP) und verbindet so die zu prüfende Last über den Prüfwiderstand (R1, RN) an die Spannung (UB oder GND);

c) die Multiplex-Einrichtung (MUX) schaltet die am Verbindungspunkt zwischen Prüfwiderstand (R1, RN) und zu prüfender Last (L1, LN) anliegende Spannung (U1, UN) auf den Analog/Digital-Wandler (ADW), welcher das Spannungssignal (U1, UN) in einen Digitalwert wandelt und einem Mikrocomputer (MC) zur Auswertung zuführt.

7. Verfahren nach Anspruch 6, dadurch gekennzeichnet, daß ein Analog/Digital-Wandler (ADW bzw. ADW') die Höhe der Betriebsspannung (UB) als Digitalwert an den Mikrocomputer (MC) gibt und daß der Mikrocomputer (MC) aus beiden Digitalwerten und dem Wert des Prüfwiderstandes (R1, RN) den Widerstand der zu überprüfenden Last (L1, LN) berechnet.